(19) Europäisches Patentamt

European Patent Office

Office européen des brevets

(11) Veröffentlichungsnummer : **0 038 440**
**B1**

(12) **EUROPÄISCHE PATENTSCHRIFT**

(45) Veröffentlichungstag der Patentschrift :
**13.06.84**

(21) Anmeldenummer : **81102397.7**

(22) Anmeldetag : **30.03.81**

(51) Int. Cl.³ : **H 03 F  1/06, H 03 F  3/24**

(54) **Schaltstufe zur Ansteuerung einer Tetrode.**

(30) Priorität : **18.04.80 AT 2099/80**

(43) Veröffentlichungstag der Anmeldung :
**28.10.81 Patentblatt 81/43**

(45) Bekanntmachung des Hinweises auf die Patenterteilung : **13.06.84 Patentblatt 84/24**

(84) Benannte Vertragsstaaten :
**CH DE FR GB LI**

(56) Entgegenhaltungen :
**DE-C-  724 172**
**DE-C-  808 248**
**Technical Manual der Us Firma 'Harris' S. 38-40**

(73) Patentinhaber : **SIEMENS AKTIENGESELLSCHAFT**
**Berlin und München Wittelsbacherplatz 2**
**D-8000 München 2 (DE)**

(72) Erfinder : **Willer, Walter**
**Rottersdorf 23**
**A-3125 Statzendorf (AT)**
Erfinder : **Fuchs, Peter, Dipl.-Ing.**
**Praterstrasse 74**
**A-1020 Wien (AT)**

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

## Beschreibung

Die Erfindung bezieht sich auf eine Schaltstufe zur Ansteuerung einer Tetrode, wobei die Röhre optimal ausgelastet werden kann und mit sehr hohem Wirkungsgrad arbeitet.

Bei der Auslegung von Verstärkerröhren für Impulsbetrieb (Schaltbetrieb) müssen die Gitterspannungen entsprechend dem maximalen und dem minimalen Anodenstrom bemessen werden, was jedoch bei Zwischenwerten des Anodenstromes zu Überlastungen der Gitter der Röhre sowie zu unnötigen Anodenverlustleistungen führt.

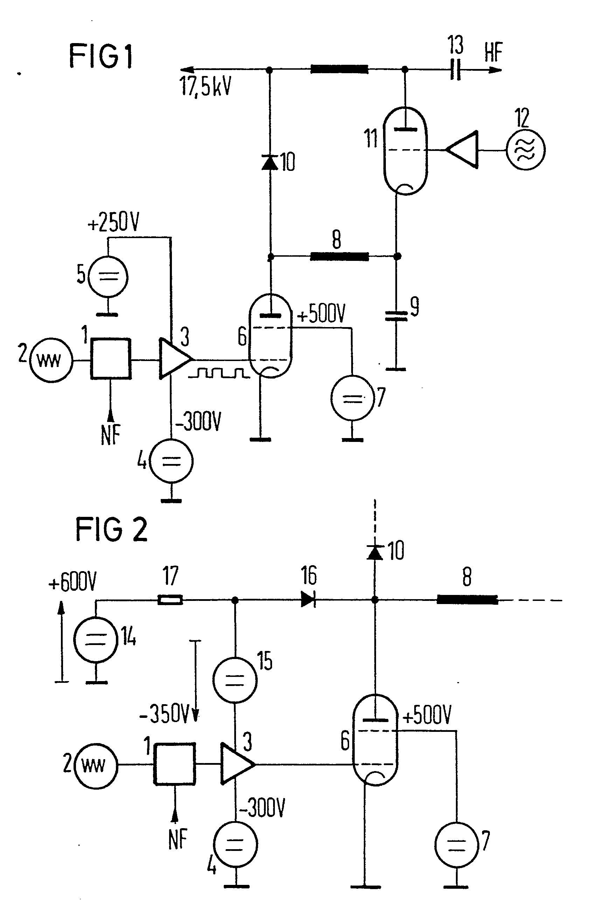

Zum besseren Verständnis der Erfindung ist in Fig. 1 der Zeichnung ein Sender bekannter Bauart mit einer Verstärkerstufe für pulsdauermodulierte Signale dargestellt und im folgenden beschrieben :

Aus dem zu übertragenden niederfrequenten Signal NF wird in einem Modulator 1 unter Zuhilfenahme von in einem Impulsgenerator 2 erzeugten Dreiecksimpulsen eine Serie von mit dem NF-Signal dauermodulierten Impulsen gewonnen, die dem Eingang eines Schaltverstärkers 3 zugeführt wird. Dieser schaltet während der Impulspausen ein von einer Gleichspannungsquelle 4 erzeugte Gleichspannung von − 300 V und während der Dauer der Impulse eine von einer weiteren Gleichspannungsquelle 5 erzeugte Gleichspannung von + 250 V an das Steuergitter der Tetrode 6 der Verstärkerstufe. Die Schirmgitterspannung von + 500 V der Tetrode 6 wird von einer Gleichspannungsquelle 7 geliefert. Die Tetrode 6 liefert die am Steuergitter angelegten Impulse verstärkt an das mit der Spule 8 und dem Kondensator 9 angedeutete Tiefpaßfilter. Eine Freilaufdiode 10 entlädt die Spule 8, wenn die Tetrode 6 gesperrt ist. Das Tiefpaßfilter unterdrückt die Schaltfrequenzen und läßt nur den Gleichspannungs- bzw. NF-Anteil des Signales an die Kathode der HF-Senderöhre 11, welche von einem Steuersender 12 mit der Trägerfrequenz angesteuert wird. Über einen Ausgangskoppelkondensator 13 gelangt das amplitudenmodulierte Signal an ein Anpassungsfilter.

Bei dieser bekannten Schaltung ergeben sich in Bezug auf die Tetrode 6 folgende Schwierigkeiten : Wenn der positive Wert der konstanten Gitterspannung (+ 250 V) dem maximal erforderlichen Strom der Anode bei der gewünschten Restspannung entspricht, dann ist die Tetrode 6 aber in Momenten, in denen sich ein kleiner Anodenstrom einstellt, viel zu positiv angesteuert und die Restspannung der Tetrode 6 würde als Folge davon weit unter die Schirmgitterspannung sinken und einen beträchtlichen Schirmgitterstrom und Steuergitterstrom hervorrufen. Es ergeben sich dann unerwünschte Bremsfeldschwingungen. Wird hingegen die Gitterspannung zu gering gewählt, dann ergibt sich eine zu hohe Restspannung an der Tetrode 6, was zu unerwünschter Verlustleistung Anlaß gibt.

Die Erfindung hat sich die Aufgabe gestellt, diese Nachteile zu vermeiden und erzielt dies bei einer Verstärkerstufe, deren Steuergitter im Rhythmus der modulierten Impulse an eine Gitterspannungsquelle angeschaltet wird, dadurch, daß die Gitterspannungsquelle aus zwei in Bezug auf das Steuergitter gegensinnig aneinandergeschalteten Teilspannungsquellen besteht, deren gemeinsame Verbindungsstelle über eine Stauerdiode an die Anode der Verstärkerröhre angeschlossen ist. Gemäß einem weiteren Merkmal der Erfindung ist zwischen der einen Teilspannungsquelle und der Verbindungsstelle ein Widerstand eingeschaltet, um eine Anpassung an das Kennlinienfeld der Verstärkerröhre zu erleichtern.

Ein Ausführungsbeispiel der Erfindung ist in Fig. 2 der Zeichnung dargestellt. Die Schaltung weist gegenüber der in Fig. 1 dargestellten bekannten Schaltung den wesentlichen Unterschied auf, daß die Teilspannungsquelle 5 in Fig. 1 ersetzt ist durch zwei gegeneinander geschaltete Teilspannungsquellen 14 und 15 und daß die Verbindungsstelle zwischen den Teilspannungsquellen 14 und 15 über eine Steuerdiode 16 mit der Anode der Verstärkerröhre 6 verbunden ist. Im speziellen ist zwischen der Verbindungsstelle und der Teilspannungsquelle 14 ein Widerstand 17 eingeschaltet.

Die Teilspannungsquelle 14 besitzt eine Gleichspannung von 600 V und die Teilspannungsquelle 15 eine Gleichspannung von 350 V. Da die beiden Spannungsquellen gegeneinander geschaltet sind, ergeben sie an dem Steuergitter der Verstärkerröhre 6 eine Differenzspannung von 250 V, ebenso wie im bekannten Beispiel die Spannungsquelle 5. Wenn jedoch bei der erfindungsgemäßen Schaltung die Anodenspannung unter den Wert von 600 V absinkt, wird die Diode 16 leitend und verringert am anodenseitigen Ende des Widerstandes 17 die Spannung, wodurch auch die positive Schaltspannung am Verstärker 3 und damit auch am Steuergitter entsprechend vermindert wird, so daß sich nun ein für die Röhre 6 optimales Kennlinienfeld im Schaltbetrieb ergibt. Die Restspannung der Röhre 6 bleibt nahezu konstant und somit unabhängig vom Anodenstrom und zwar gerade so hoch, daß die Gitter der Röhre nie überlastet werden und auch keine Bremsfeldschwingungen in Momenten kleinen Anodenstromes auftreten. Weiters erübrigt sich auch eine bewußte Vorverzerrung oder die Überlagerung von NF-Anteilen am Gitter, was bisher zwecks Kompensation von Verzerrungen notwendig war. Die Röhre 6 liefert eine Rechteckspannung hoher Qualität, wie sie bei Pulsmodulation erforderlich ist.

Ein weiterer Vorteil besteht darin, daß das Schirmgitter bei Ausfall der Anodenspannung nicht mehr ausgeschaltet werden muß, da sich in diesem Fall der Strom über die Anode, die das Gitter mitzieht, so klein hält, daß keine Überlastung des Schirmgitters eintritt.

Durch die erfindungsgemäße Schaltung kann die Verstärkerröhre 6 gegenüber der herkömmlichen Schaltröhre leistungsmäßig auf ein Viertel reduziert werden. Der erzielte Wirkungsgrad der Röhre liegt dabei über 95 %. Die Restspannung der Röhre schwankt nur mehr um etwa 150 V zwischen Momenten tiefster und höchster Modulation, während sie bei den bekannten Schaltungen bis um 1 kV schwankte, was auch einen zusätzlichen Klirrfaktor der NF-Information bedeutet.

**Ansprüche**

1. Schaltstufe zur Ansteuerung einer Tetrode (6) für Impulsbetrieb, welche optimal angesteuert werden kann und mit sehr hohem Wirkungsgrad arbeitet, wobei während der Dauer der Impulse eine durchgeschaltete Gleichspannung (5) an das Steuergitter der Tetrode (6) gelegt ist, dadurch gekennzeichnet, daß die Gitterspannungsquelle aus zwei in Bezug auf das Steuergitter gegensinnig aneinandergeschalteten Teilspannungsquellen (14, 15) besteht, deren gemeinsame Verbindungsstelle über eine Steuerdiode (16) an die Anode der Tetrode (6) angeschlossen ist.

2. Schaltstufe nach Anspruch 1, dadurch gekennzeichnet, daß zwischen der einen Teilspannungsquelle (14) und der Verbindungsstelle ein Widerstand (17) eingeschaltet ist.

**Claims**

1. A switching stage for controlling a tetrode (6) for pulse operation, with optimal control and very highly efficient' operation, where during the duration of the pulses a switched-through d. c. voltage (5) is connected to the control grid of the tetrode (6), characterised in that the grid voltage source consists of two partial voltage sources (14, 15) mutually oppositely connected with respect to the control grid with their common connection point linked to the anode of the tetrode (6) by means of a control diode (16).

2. A switching stage as claimed in Claim 1, characterised in that a resistor (17) is inserted between the one partial voltage source (14) and the connection point.

**Revendications**

1. Etage de commutation pour la commande d'une tétrode (6) pour un fonctionnement impulsionnel, qui peut être commandée de façon optimale et opérer avec un rendement très élevé, une tension continue transmise (5) étant appliquée à la grille de commande de la tétrode (6) pendant la durée des impulsions, caractérisé par le fait que la source de tension de grille est constituée par deux sources de tension partielles (14, 15), branchées en série en sens opposé par rapport à la grille de commande, et dont le point de jonction commun est relié à l'anode de la tétrode (6) par l'intermédiaire d'une diode de commande (16).

2. Etage de commutation suivant la revendication 1, caractérisé par le fait qu'une résistance (17) est insérée entre une des sources de tension partielles (14) et le point de jonction.

FIG 1

FIG 2